# EUROPÄISCHE PATENTANMELDUNG

(11) **EP 0 717 587 A2**
(43) Veröffentlichungstag der Anmeldung: **19.06.1996**
(21) Anmeldenummer: 95119402.6
(22) Anmeldetag: 08.12.1995
(51) Int. Cl.: H05K 3/46, H05K 3/34

(54) **Mehrlagen-Leiterplatte**

(30) Priorität: 12.12.1994 DE 9419868 U
(71) Anmelder: SIEMENS AKTIENGESELLSCHAFT, D-80333 München (DE)
(72) Erfinder: Ben Ameur, Raouf, D-67346 Speyer (DE)

(57) **Zusammenfassung**

Die Erfindung betrifft eine Mehrlagen-Leiterplatte mit mindestens einer Verdrahtungsschicht, die zumindest eine innere Verdrahtungslage (8, 9) und eine äußere, der Oberseite der Mehrlagen-Leiterplatte benachbarte Verdrahtungslage (10) aufweist, die jeweils durch eine Lage (11, 12) aus elektrisch isolierendem Material im wesentlichen getrennt sind, wobei die Lage (11, 12) aus elektrisch isolierendem Material Aussparungen zur Verbindung bestimmter Leitungen der Verdrahtungslagen aufweist. Um ein leicht dotierbares Lotdepot auf Anschlußstellen für elektronische Bauelemente zu erzeugen und dadurch die Fehlersicherheit bei der Flachbaugruppenherstellung zu erhöhen, ist zumindest eine versenkte Anschlußstelle auf einer inneren Verdrahtungslage (9) angeordnet und sind in den Lagen (10, 12, 15) oberhalb der inneren Verdrahtungslage (9) Aussparungen vorgesehen, deren Wandungen eine im wesentlichen becherförmige Vertiefung in der Mehrlagen-Leiterplatte mit der Anschlußstelle als Becherboden bilden.

Die Erfindung findet Anwendung in der gesamten Elektronik.

## Beschreibung

Die Erfindung betrifft eine Mehrlagen-Leiterplatte nach dem Oberbegriff des Anspruchs 1.

In elektronischen Schaltungen werden häufig Leiterplatten als mechanischer Träger und elektrisches Verbindungselement für elektronische Bauelemente verwendet. Aus der EP-OS 0 478 313 ist eine Mehrlagen-Leiterplatte bekannt, bei welcher auf der einen Seite einer Trägerschicht aus elektrisch isolierendem Material eine Lage aus elektrisch leitendem Material zur Versorgung der elektronischen Bauelemente mit der Versorgungsspannung und auf der anderen Seite eine Verdrahtungsschicht aufgebracht sind. An der Oberfläche der Verdrahtungsschicht befinden sich flächig ausgebildete Anschlußstellen für oberflächenmontierbare Bauelemente. Leitungen zur elektrischen Verbindung der Anschlußstellen verlaufen innerhalb der Verdrahtungsschicht. Zur Herstellung einer solchen Verdrahtungsschicht werden zunächst bei einem sogenannten Kern, einem Laminat aus glasfaserverstärktem Epoxydharz mit beidseitiger Kupferkaschierung, durch Wegätzen überflüssiger Kupferflächen auf einer Seite Leitungen einer ersten Verdrahtungslage erzeugt. Danach wird eine isolierende, photosensitive Harzschicht aufgetragen, in der an bestimmten Stellen durch Beleuchtung Aussparungen erzeugt werden. Darauf wird eine weitere Kupferschicht aufgetragen, in der wiederum durch Ätzen die Leitungen einer zweiten Verdrahtungslage entstehen. Leitungen der ersten und der zweiten Verdrahtungslage, deren Verlauf dieselbe Aussparung in der photosensitiven Schicht kreuzt, sind auf diese Weise durch sogenannte Umsteiger miteinander verbunden. Falls erforderlich, können in derselben Weise noch weitere Verdrahtungslagen, die durch isolierende Lagen im wesentlichen voneinander getrennt sind, aufgebracht werden. Die für elektronische Bauelemente erforderliche Versorgungsspannung wird von der Lage aus elektrisch leitendem Material, die sich auf der anderen Seite des isolierenden Trägermaterials befindet, über sogenannte Durchkontaktierungen, also die Mehrlagen-Leiterplatte durchdringende Bohrungen mit leitend beschichteter Innenfläche, Anschlußstellen auf der Oberfläche der Verdrahtungsschicht zugeführt. Bezüglich weiterer Angaben zur Herstellung einer derartigen Mehrlagen-Leiterplatte wird auf die obengenannte Veröffentlichung verwiesen. Aufgrund der geringen Zahl von Durchkontaktierungen und der feinen Strukturen der Leiterbahnen, die bei der bekannten Mehrlagen-Leiterplatte möglich sind, wird eine hohe Packungsdichte elektronischer Bauelemente bei geringer Anzahl von Verdrahtungslagen erreicht.

Die Miniaturisierung von Halbleiterstrukturen elektronischer Bauelemente führt dazu, daß immer mehr Funktionen in einem Bauelement integriert werden können. Allerdings nimmt die Zahl der für die Kommunikation nach außen notwendigen Anschlüsse stark zu. Dadurch bedingt, werden auch die Abmessungen und Abstände der Bauelemente-Anschlüsse kleiner. Durch den entsprechend geringeren Abstand der Anschlußstellen auf der Mehrlagen-Leiterplatte wird die Fertigungssicherheit des Lotpastenauftrages im Siebdruck beeinträchtigt und die Gefahr von Kurzschlüssen zwischen den Anschlüssen durch Brückenbildung beim Lötvorgang erhöht.

Zur Verbesserung der Fertigungssicherheit ist aus dem Aufsatz "Vier unterschiedliche SSD-Verfahren im Vergleich: Für feinste Strukturen geeignet", veröffentlicht in der Zeitschrift "productronic" 10-1994, Seiten 56 bis 62, das sogenannte High-Pad-Verfahren bekannt. Bei diesem Verfahren wird der Lotauftrag in festen Lotdepots vorgenommen, die von einer Lötstoppmaske sicher umschlossen sind. Bei dem sogenannten Sipad-Verfahren wird eine Lötstoppmaske verwendet, die 0,1 mm dick ist und die Anschlußstellen auf der Leiterplatte umschließt. Sie dient gleichzeitig als Lotformmaske, welche die Menge des Lotdepots bestimmt. Das bekannte High-Pad-Verfahren hat den Nachteil, daß die Lötstoppmaske besondere Anforderungen erfüllen und insbesondere ihre definierte Dicke, die sich auch auf die Bauhöhe der Leiterplatte auswirkt, genau eingehalten werden muß. Zudem sind zusätzliche Verfahrensschritte für die Aufbringung und Bearbeitung der Lötstoppmaske erforderlich.

Der Erfindung liegt die Aufgabe zugrunde, eine Mehrlagen-Leiterplatte zu schaffen, die kostengünstig herstellbar ist und auch bei kleineren Abmessungen der Anschlußstellen eine gute Fertigungssicherheit von Flachbaugruppen ermöglicht.

Zur Lösung dieser Aufgabe weist die neue Mehrlagen-Leiterplatte der eingangs genannten Art die im kennzeichnenden Teil des Anspruchs 1 angegebenen Merkmale auf. In den Unteransprüchen sind vorteilhafte Ausführungsformen der Erfindung beschrieben.

Die Erfindung hat den Vorteil, daß aufgrund der versenkten Anordnung der Anschlußstellen Kurzschlüsse zwischen Anschlüssen elektronischer Bauelemente nach dem Lötvorgang weitgehend vermieden werden. Die zwischen benachbarten Anschlußstellen verbleibenden Stege wirken wie Barrieren, die einen Übertritt des Lots verhindern. Mit den erfindungsgemäßen Mehrlagen-Leiterplatten sind somit Flachbaugruppen in verbesserter Qualität und, da weniger Ausschuß als bei nicht versenkten Anschlußstellen produziert wird, mit geringeren Kosten herstellbar. Zudem ermöglicht die erfindungsgemäße Mehrlagen-Leiterplatte einen geringeren Rasterabstand zwischen benachbarten Anschlußstellen. Sie sind daher auch bei hochintegrierten Flachbaugruppen einsetzbar. Durch die versenkten Anschlußstellen entstehen einfach dotierbare Lotdepots, die im Dispenser- oder Siebdruck-Verfahren mit Lot bzw. Lotpaste versehen werden können und eine fehlersichere Montage elektronischer Bauelemente auf der erfindungsgemäßen Mehrlagen-Leiterplatte ermöglichen. Ein eventueller Mehraufwand zur Herstellung der erfindungsgemäß versenkten Anschlußstellen ist gegenüber der möglichen Kosteneinsparung aufgrund der größeren Fertigungssicherheit zu vernachlässigen. Die erfindungsgemäße Mehrlagen-Leiterplatte kann ohne weiteres mit den für Leiterplatten üblichen Materialien hergestellt werden. Beispielsweise werden an die Beschaffenheit der Lötstoppmaske keinerlei zusätzliche Anforderungen gestellt.

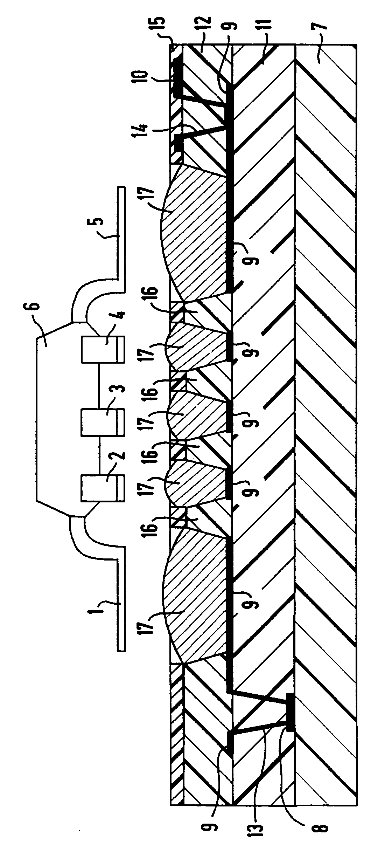

Anhand der Zeichnung, in der ein Ausführungsbeispiel der Erfindung dargestellt ist, werden im folgenden die Erfindung sowie Ausgestaltungen und Vorteile näher erläutert.

Die Figur zeigt ein Schnittbild durch eine erfindungsgemäße Mehrlagen-Leiterplatte entlang einer Linie, die durch Anschlußstellen für Anschlüsse 1 ... 5 eines für Oberflächenmontage geeigneten elektronischen Bauelementes 6 verläuft. Auf einer mechanisch stabilen Trägerschicht 7, beispielsweise aus glasfaserverstärktem Epoxydharz, ist eine Verdrahtungsschicht aufgebracht. Diese Verdrahtungsschicht weist drei Verdrahtungslagen 8, 9 und 10 auf, die jeweils durch ein elektrisch isolierendes Dielektrikum 11 bzw. 12 im wesentlichen voneinander getrennt sind. Mit einem Umsteiger 13 sowie einem Umsteiger 14 werden Verbindungen zwischen Leiterbahnen der Verdrahtungsschichten 8 und 9 bzw. 9 und 10 hergestellt. Die für die Umsteiger 13 und 14 erforderlichen Ausnehmungen im Dielektrikum 11 bzw. 12 können beispielsweise mit Photolithographie, durch Laserabtrag oder durch Plasmaätzung hergestellt werden. In anderen Ausführungsformen können die Umsteiger auch durch totale Durchkontaktierungen, welche die gesamte Mehrlagen-Leiterplatte durchdringen, ersetzt oder ergänzt werden. Eine Möglichkeit zur Herstellung einer derartigen Mehrlagen-Leiterplatte ist in der bereits erwähnten EP-PS 0 478 313 ausführlich beschrieben. Abweichend von den dort angegebenen Verfahrensschritten werden bei der Herstellung der zweiten Verdrahtungslage 9 durch Wegätzen überflüssiger Kupferflächen nicht nur Leiterbahnen, sondern auch Anschlußstellen für elektronische Bauelemente unversehrt belassen. In dem darauf aufgetragenen Dielektrikum 12 aus photosensitivem Harz werden zusätzlich zur Ausnehmung für den Umsteiger 14 auch Ausnehmungen für die Anschlußstellen, die sich in der zweiten Verdrahtungslage 9 befinden, durch Beleuchtung erzeugt. Auf das Dielektrikum 12 wird in bekannter Weise eine Kupferschicht aufgetragen, aus der wiederum durch Ätzen die Verdrahtungslage 10 geschaffen wird. Durch diesen Ätzvorgang dürfen allerdings die freiliegenden Anschlußstellen in der Verdrahtungslage 9 nicht beschädigt werden. Die dazu erforderliche Schutzfunktion kann durch ein photosensitives Ätzresist erbracht werden, das beim Ätzvorgang auch die in der Verdrahtungsschicht 10 verbleibenden Leiterzüge bedeckt. In bekannter Weise wird die Leiterplatte mit einer Lötstoppmaske 15 aus Schutzlack versehen. Durch Photolithographie werden schließlich die Kupferflächen der Anschlußstellen vom Ätzresist und von dem Schutzlack befreit. Auf diese Weise werden Trennstege 16 zwischen den Anschlußstellen erhalten, die ein Lotdepot in Form einer becherförmigen Vertiefung in der Leiterplatte bilden. Diese Lotdepots sind im Dispenser- oder Siebdruck-Verfahren einfach dotierbar und verringern das Risiko der Zinnbrückenbildung, da das Lot 17 nicht wesentlich über die Stege 18 hinausragen muß. Dieser Vorteil kann aber auch zur Verringerung des Rasterabstands zwischen den Anschlußstellen und damit zur höheren Integration einer Leiterplatte genutzt werden. Für die Fehlersicherheit und Größe des Lotdepots hat sich eine Steghöhe zwischen 0,05 und 0,3 mm als vorteilhaft erwiesen. In vorteilhafter Weise bleibt die Bauhöhe der Mehrlagen-Leiterplatte durch die erfindungsgemäße Anordnung der Anschlußstellen unbeeinflußt. Da gegenüber dem bekannten Herstellungsverfahren von Mehrlagen-Leiterplatten keine zusätzlichen Prozeßschritte erforderlich sind, wirkt sich die erfindungsgemäße Anordnung auch nicht ungünstig auf die Herstellungskosten der Mehrlagen-Leiterplatte aus. Vielmehr wird aufgrund einer Erhöhung der Fertigungssicherheit bei der anschließenden Flachbaugruppenfertigung durch die erfindungsgemäße Anordnung der Anschlußstellen eine Senkung der Herstellungskosten elektronischer Geräte insgesamt erreicht.

Obwohl die Erfindung anhand einer Leiterplatte mit nur einer Verdrahtungsschicht und einer Bestückungsseite als Ausführungsbeispiel verdeutlicht wurde, ist sie ohne Einschränkung auch auf der Ober- und Unterseite einer Leiterplatte mit beidseitiger Bestückung anwendbar. Dabei ist es gleichfalls unwesentlich, ob es sich um eine starre oder eine flexible Leiterplatte handelt oder ob die Wandungen der becherförmigen Vertiefungen kegelstumpfartig geneigt oder zylinderförmig senkrecht angeordnet sind.

## Patentansprüche

1. Mehrlagen-Leiterplatte
- mit Anschlußstellen für elektronische Bauelemente,
- mit mindestens einer Verdrahtungsschicht, die zumindest eine innere Verdrahtungslage (8, 9) und eine äußere, der Oberseite der Mehrlagen-Leiterplatte benachbarte Verdrahtungslage (10) aufweist, die jeweils durch eine Lage (11, 12) aus elektrisch isolierendem Material im wesentlichen getrennt sind, wobei die Lage (11, 12) aus isolierendem Material Aussparungen zur Verbindung bestimmter Leitungen der Verdrahtungslagen (8, 9, 10) aufweist,
**dadurch gekennzeichnet,**
- daß zumindest eine Anschlußstelle versenkt auf einer inneren Verdrahtungslage (8, 9) angeordnet ist und
- daß in den Lagen (10, 12, 15) oberhalb der inneren Verdrahtungslage (8, 9) Aussparungen vorgesehen sind, deren Wandungen eine im wesentlichen becherförmige Vertiefung in der Mehrlagen-Leiterplatte mit der Anschlußstelle als Becherboden bilden.

2. Mehrlagen-Leiterplatte nach Anspruch 1, **dadurch gekennzeichnet,**
- daß mehrere innere Verdrahtungslagen (8, 9) vorhanden sind und
- daß die versenkte Anschlußstelle auf der inneren Verdrahtungslage (9) angeordnet ist, die der äußeren Verdrahtungslage (10) benachbart ist.

3. Mehrlagen-Leiterplatte nach Anspruch 1 oder 2, **dadurch gekennzeichnet,**
- daß die Höhe der versenkten Anschlußstelle zwischen 0,05 und 0,3 mm beträgt.
